Europäisches Patentamt

European Patent Office

Office européen des brevets

(19)

(11) Publication number: 0 165 803
A2

## (12) EUROPEAN PATENT APPLICATION

(21) Application number: 85304343.8

(22) Date of filing: 17.06.85

(51) Int. Cl.⁴: G 01 R 15/07
G 01 R 31/08

(30) Priority: 18.06.84 JP 125790/84

(43) Date of publication of application:
27.12.85 Bulletin 85/52

(84) Designated Contracting States:
CH DE FR GB LI SE

(71) Applicant: SUMITOMO ELECTRIC INDUSTRIES LIMITED
No. 15, Kitahama 5-chome Higashi-ku
Osaka-shi Osaka 541(JP)

(72) Inventor: Itaka, Koshi c/o Osaka Works
Sumitomo Elec. Ind. Ltd. 1-3, Shimaya 1-chome
Konohana-ku Osaka(JP)

(72) Inventor: Fujieda, Keishi c/o Osaka Works
Sumitomo Elec. Ind. Ltd. 1-3, Shimaya 1-chome
Konohana-ku Osaka(JP)

(72) Inventor: Hara, Takushi c/o Osaka Works
Sumitomo Elec. Ind. Ltd. 1-3, Shimaya 1-chome
Konohana-ku Osaka(JP)

(72) Inventor: Nakamura, Kizashi c/o Osaka Works
Sumitomo Elec. Ind. Ltd. 1-3, Shimaya 1-chome
Konohana-ku Osaka(JP)

(74) Representative: Warren, Anthony Robert et al,
BARON & WARREN 18 South End Kensington
London W8 5BU(GB)

(54) A system and an apparatus for locating a grounding fault on electric power equipment.

(57) This invention concerns a system and an apparatus for locating a grounding fault on electric power equipment such as a power cable (11). Optomagnetic sensors (12a, 12b) are installed in spaced relation at each end of a section (L) of the cable (11). Signals from the optomagnetic sensors are transmitted to associated light-electricity conversion circuits (14a, 14b) by means of associated optical fiber cables (13a, 13b). A discrimination circuit (15) determines whether or not a grounding fault has occurred, and where it has occurred, based on the output signals of the light-electricity conversion circuits (14a, 14b). The determination is based on the magnetic level difference or phase difference between the latter output signals, or on a combination of the two.

FIG.1A

## A SYSTEM AND AN APPARATUS FOR LOCATING A GROUNDING FAULT ON ELECTRIC POWER EQUIPMENT

This invention relates to a system and an apparatus for locating a grounding or earth fault on electric power equipment which employs the Faraday effect.

When a grounding fault occurs on electric power equipment such as electric power cables or gas insulated substations (GIS), it is necessary to see if the grounding fault has happened inside a certain section or outside thereof. Hitherto, in order to cope with this kind of trouble, there has been used such a system that detects the fault location by a signal electric current transmitted from a pair of current transformers placed at each end of each section. However, in the system, the distance between the current transformers and a signal processing circuit which discriminates those signals from the transformers is so long, and those signals travel in such a long electric wire, that the system is apt to be affected by intervening noises. In addition, since current transformers are attached to a high-tension cable in an exposed condition, contact of current transformers and a high-tension cable, or mis-judgement resulting from the current transformers' breaking by mechanical reasons, is very likely to occur. Moreover, it is one of the disadvantages of this system that the size of current transformers to be installed at both ends of the electric power equipment is very large.

Under the circumstances, it is an object of this invention to provide a system and an apparatus for locating a section where electric power equipment develops a fault which has a relatively, simple construction but is capable of reducing or eliminating mis-judgement.
It is another object of this invention to provide a compactly designed apparatus which is capable of virtually immediately locating a section where electric power equipment develops a fault.

The invention will be more readily understood, from a consideration for the following description taken in connection with the accompanying drawings, wherein:-

Fig. 1A is a schematic diagram illustrating the construction of an apparatus according to one embodiment of this invention for locating a grounding fault on electric power equipment;

Fig. 1B is a schematic diagram illustrating the construction of an apparatus according to another embodiment of this invention for locating a grounding fault on electric power equipment in which a plurality of optomagnetic sensors are installed;

Fig. 1C is a block circuit diagram which shows a construction of the apparatus of Fig. 1A;

Fig. 1D is a diagram showing optomagnetic sensors attached to the outside of a grounded metallic sheath of electric power equipment;

Fig. 1E is a diagram showing optomagnetic sensors attached to the inside of a grounded metallic sheath of electric power equipment;

Fig. 2 is a diagram which shows the principle of an optomagnetic sensor of the apparatus of Fig. 1A;

Fig. 3 is a diagram illustrating the construction of the optomagnetic sensor;

Fig. 4 is a circuit diagram of the optomagnetic

0165803

sensor;

Fig. 5 is a diagram which shows wave forms of a signal electric current at the points A and B in Fig. 1A, and wave forms of output signals from a signal processing circuit;

Fig. 6 is a diagram which shows wave forms of output signals from an exclusive "OR" circuit, and from an integrator in Fig. 1C, both under normal operating conditions and upon occurrence of a grounding fault inside the section L;

Fig. 7 is a diagram which illustrates that signals of the optomagnetic sensors are composed of three-phase sequence components;

Fig. 8A is a block diagram which shows a fully duplicated circuit used for the apparatus embodying this invention;

Fig. 8B is a block diagram which shows a partially duplicated circuit used for the apparatus embodying this invention;

Fig.9A is a block diagram which shows an example of making self-diagnosis of the system;

Fig. 9B is a block diagram which shows another example of making self-diagnosis of the system.

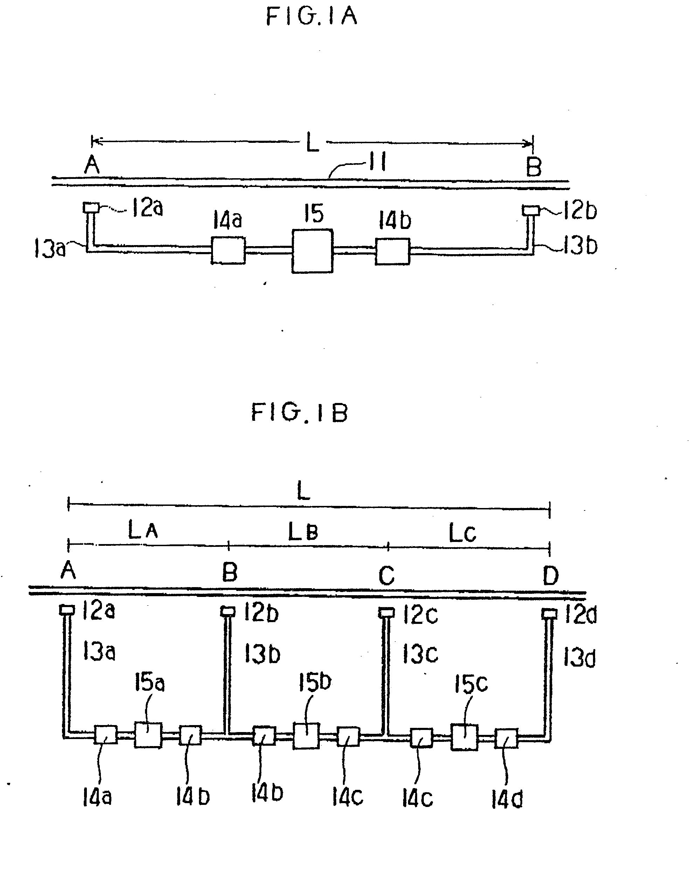

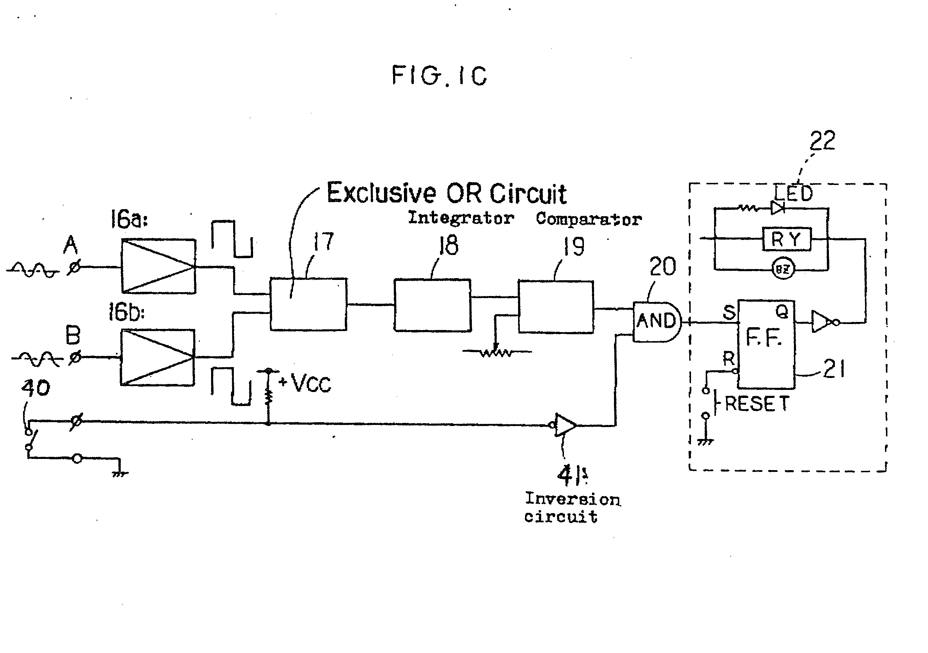

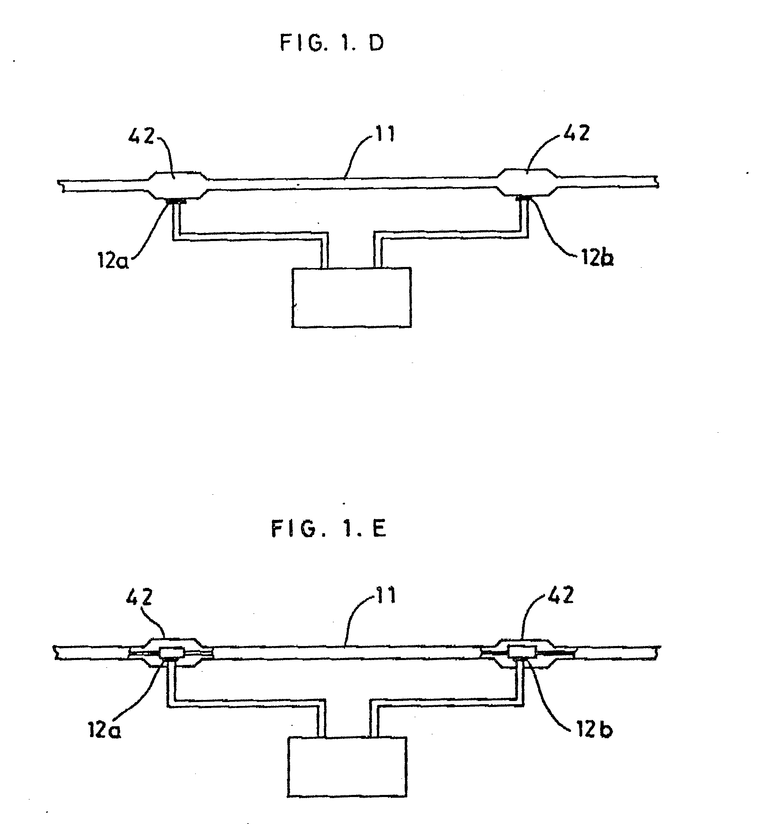

As Fig. 1 shows, the seciton L of an electric power cable 11 is checked for trouble, i.e. faults,by optomagnetic sensors.  Optomagnetic sensors 12a, 12b are installed at both ends of the section L.  An optical output corresponding to a conductor current which is transmitted from both the sensors 12a, 12b individually travels to signal processing circuits 14a, 14b by way of double-cored optical fiber cables 13a, 13b.

The signal processing circuits 14a, 14b transmit the optical signal mentioned above to a discrimination circuit 15 upon converting it into an electric signal corresponding thereto.

The discrimination circuit 15 determines whether or not a grounding fault has occurred, or in which section, if any, the fault has occurred, based on the transmitted electric signal.

Fig. 1B shows that the section L is divided into subsections LA, LB and LC, where a plurality of optomagnetic sensors (four in this case) are provided separately, i.e. scattered or distributed, in such a way that the subsection where a grounding fault has occurred can be determined by checking signals from each pair of adjacent sensors. In this respect, it is not always necessary to check signals from a couple of adjacent sensors in order to find a fault location, and any two of the sensors, such as 12a and 12c, can be chosen in finding a probable fault location.

Fig. 1C is a block diagram of the discrimination circuit 15 shown in Fig. 1A. The discrimination circuit contains amplifiers 16a, 16b for reshaping a signal input from the points A and B into rectangular waves and amplifying them, and an exclusive "OR" circuit 17 for converting signals from the amplifiers 16a, 16b into an exclusive "OR". An output signal from the exclusive "OR" circuit is integrated by means of an integrator 18 and sent to a comparator 19 for comparison with a certain or predetermined standard voltage level.

The comparator 19 sends the signal "High" to an AND circuit 20 when the voltage of the input signal is higher than the standard voltage based on the logical level.

The AND circuit 20 receives signals from the comparator 19 together with signals from a relay circuit 40 upon inverting the latter signals by means of a inversion circuit 41, where the relay circuit, one side of which is grounded, achieves continuity, i.e. is made, when a grounding fault occurs. An indication circuit 22 indicates whether or not a grounding fault has occurred and in what section the fault has occurred based on the signals from the AND circuit 20.

Fig. 1D shows optomagnetic sensors 12a, 12b attached to the outside of a grounded metallic sheath of electric power equipment. Fig. 1E shows optomagnetic sensors 12a, 12b attached to the inside of a grounded metallic sheath of electric power equipment.

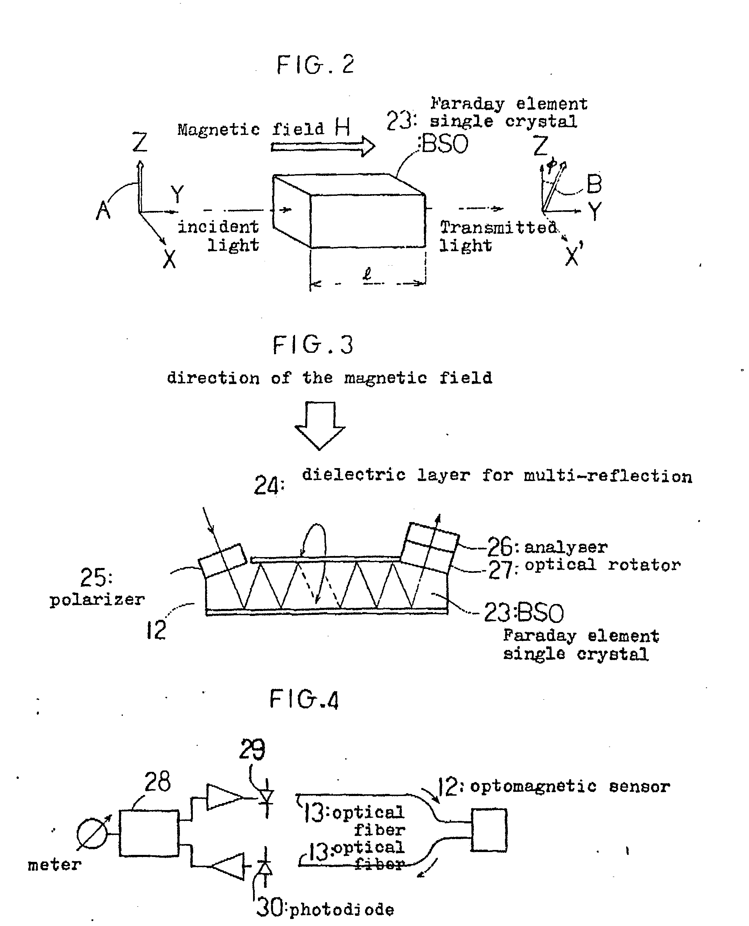

In connection with the above, there will firstly be described an optomagnetic sensor applied to this invention. Fig. 2 is a diagram showing the principle of the optomagnetic sensor. When a linearly polarized light having a certain angle of polarization A hits a Faraday element 23 composed of a bismuth silicon oxide (BSO) single crystal, the magnetic field H is impressed on the Faraday element in a direction parallel to the advancing direction of the incident polarized light. Also, when the polarized light passes through the Faraday element 23, Faraday rotation occurs. As a result, the plane of polarization A is rotated by an angle of $\emptyset$.

That is, after having passed through the Faraday element, the polarized light turns into light having a plane of polarization B.  If the intensity of the magnetic field is H, the length of the Faraday element is l, and Verdet's constant is Ve, then the angle of rotation $\emptyset$ is ex-expressed as:

$$\emptyset \ = \ Ve \cdot H \cdot l \qquad (1)$$

Fig. 3 is a diagram showing the construction of the optomagnetic sensor which makes use of the Faraday rotation.  In the magnetic sensor 12, a BSO single crystal or the like is used as a Faraday element.  The Faraday element is covered with a dielectric reflecting layer 24 for multi-reflection, except for the sides where incident light enters and where transmitted light leaves.

A polarizer 25 is placed on the side where incident light enters, in order to cause linear polarization. An analyser 26 is placed on the side where transmitted light emerges at an angle of 45° to the polarizer 25. Moreover, an optical rotator 27 is placed between the analyser 26 and the Faraday element 23 in order to rotate the plane of polarization of the transmitted light by a certain degree.

Incidentally, the transmittance T of the optomagnetic sensor 12 (i.e. the ratio of the intensity of the transmitted light to the intensity of the incident light) is expressed by the following equation:

$$T \ = \ ( \ 1 + \sin 2\emptyset) \ / \ 2 \qquad (2)$$

If $2\emptyset$ is far less than 1, then the equation (2) may be rewritten as follows:

$$T = ( 1 + 2\emptyset ) / 2 . \qquad (3)$$

In the case where the intensity of the magnetic field H is alternating, and expressed by $H_o \sin wt$, the following equation can be derived from the above equations (1) and (3):

$$T = ( 1 + 2Ve \cdot H_o \sin wt.1 ) / 2 \qquad (4)$$

The absolute intensity of the magnetic field $H_o$ can be obtained by the determination of the ratio of a direct current component to an alternating current component (i.e. magnitude of modulation) of the transmitted light.

Fig. 4 is a diagram showing the fundamental construction of the circuit in the optomagnetic sensors used to determine a magnitude of the impressed magnetic field H. As Fig. 4 shows, certain voltage signals are transmitted from a signal processing circuit 28 to a light emitting diode 29. The light emitting diode sends the optomagnetic sensor 12 optical signals of certain intensity by way of the optical fiber cable 13 in response to the above voltage signals.

Transmitted light leaving the optomagnetic sensor 12 travels through the optical fiber cable 13 to a photodiode 30. The photodiode sends the signal processing circuit 28 electric signals in response to the transmitted light. Upon receipt of the electric signals, the signal processing circuit 28 determines the ratio of a direct current component to an alternating current component and then sends the optomagnetic sensor 12 electric signals in correspondence to the intensity and the frequency of the impressed magnetic field H, where the impressed magnetic field is induced by a conductor current.

Now that the intensity of the magnetic field is proportional to the intensity of the conductor current, the change in the magnetic field corresponds to the change in the conductor current. After all, the level of the voltage signals transmitted from the signal processing circuit 28 corresponds to the magnitude of the conductor current. Therefore, detecting and discriminating signals from the signal processing circuit 28 makes it possible to sense the change in the conductor current.

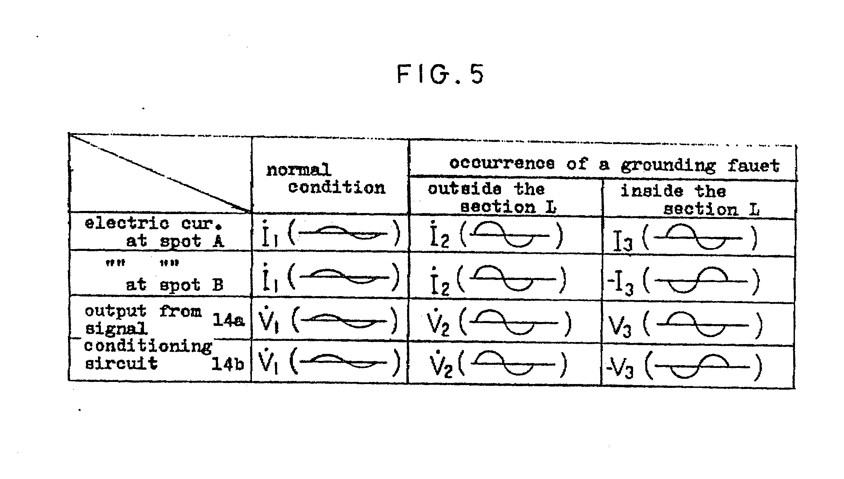

Fig. 5 is a tabulated illustration of electric current waves at the points A and B and output signal waves from the signal processing circuits 14a, 14b. Those wave forms are arranged in the Figure, from left to right, in the order of non-occurrence (normal condition) and the occurrence of a grounding fault inside the section L and outside thereof.

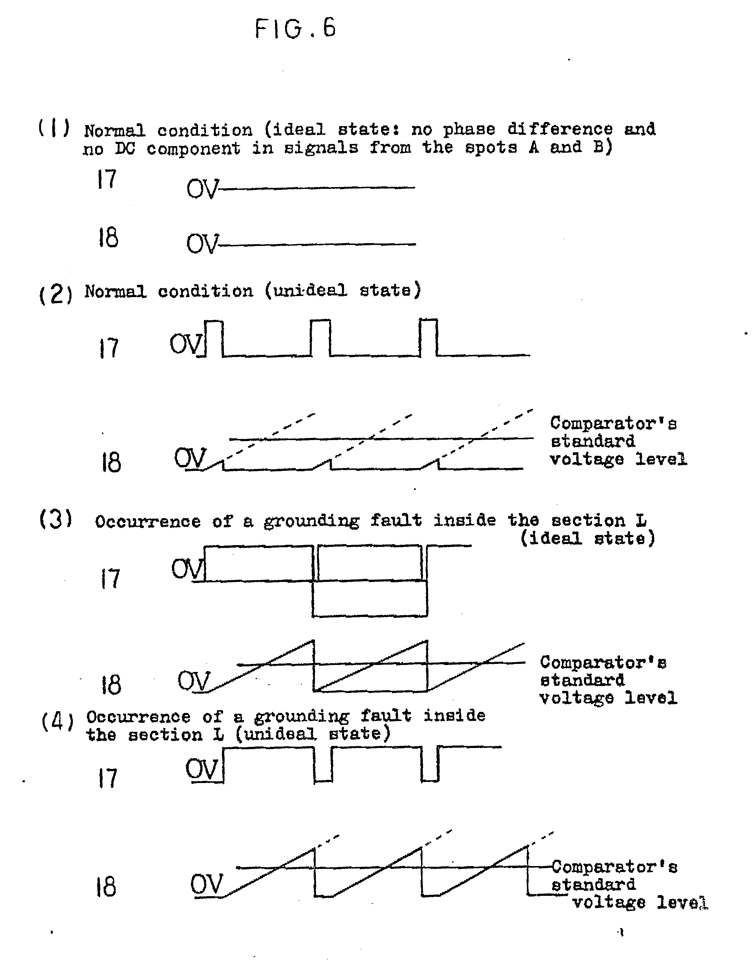

Fig. 6 is a diagram illustrating output signal waves from the exclusive "OR" circuit 17 and the integrator 18. Those wave forms are arranged in the Figure in the order of non-occurrence and the occurrence of a grounding fault inside the section L.

The action of the discriminating circuit 15 will be described with reference to Figs. 1C, 5 and 6. Once a grounding fault occurs somewhere, continuity of the relay circuit 40 occurs, i.e. the relay contacts close. From this, it is noticed that a fault has occurred anyway. A relay circuit of a protective breaker may be used in this case.

When a grounding fault has happened inside the section L, output signal waves from the signal processing circuits 14a, 14b differ in phase from each other by 180°, as seen from Fig. 5. Those signals are amplified by the amplifiers 16a, 16b, and re-shaped into a rectangular wave. The amplified signals are converted into an exclusive "OR" in the exclusive "OR" circuit 17. Thus, output signals from the exclusive "OR" circuit 17 are in the form of a wide rectangular wave having a high output level. The integrator 18 effects integration only when the output signals are present on the positive level. Hence, as seen from Fig. 6, output signal waves from the integrator are triangular in shape, and some of those signal waves surpass the standard voltage level predetermined in the comparator 19.

As soon as output signals from both the comparator 19 and the relay circuit 40 are put in the AND circuit 20, the indication circuit 22 indicates the occurrence of a fault in the section L by means of a light emitting diode LED, and a buzzer BZ, according to output signals from the AND circuit.

When a grounding fault has happened outside the section L, the input signal waves applied to the exclusive "OR" circuit 17 have almost the same in phase, as seen from Fig. 5. On account of this, output signals from the exclusive "OR" circuit 17 do not differ from those in the normal condition whatever the amplitude level of the input signals. In this case, all the circuits after the exclusive "OR" circuit, except for the relay circuit 40, generate much the same signals as those in the normal condition, so that no indication indicative of the occurrence of a grounding fault occurs. From this, the fault is judged to have happened outside the section L.

As will be apparent from the above, according to this invention optomagnetic sensors are employed in place of current transformers used in conventional systems. Amplifiers with high amplifying capacity are located just before the exclusive "OR" circuit in series in order to determine the location of a ground fault. Output signals from the exclusive "OR" circuit are integrated by the integrator and then compared with a standard voltage level by the comparator. Consequently, the apparatus embodying this invention can be miniaturized and simplified in construction. Moreover, since the integrator is located after the exclusive "OR" circuit, it is possible to make a correct determination of the occurrence/non-occurrence and/or the location of a grounding fault in terms of a given section, even if signals from a signal processing circuit have a little gap in their phase, or a direct current component in themselves to some extent.

In this specification, an apparatus of single phase type is shown in Figs. 1A and 1B for the purpose of illustrating a system for receiving signals from optomagnetic sensors. However, in order to make the system much simpler, it is similarly possible to make the vectorial addition of three-phase sequence components and make a judgement or determination by using a zero-phase sequence component obtained from the addition thereof.

This invention employs optomagnetic sensors to which the Faraday effect is applied. The optomagnetic sensors can catch electric signals exhibiting a phase difference when a grounding fault has occurred in a given section. It is quite unnecessary to adjust their mutual disposition, even when the optomagnetic sensors are installed in a place affecting magnetism due to electric current carried by a transmission line. That is, fine adjustment in the attachment of the optomagnetic sensors can be avoided by providing an automatic gain controller for the amplifiers for electric signals converted from optical signals, and connecting its output side to the differential circuit in such a way that the output of the differential circuit is zero or nearly zero so long as the electric signals do not differ in phase from each other. The system requires no significant technical skill and can be made relatively easily.

Moreover, in order to increase the reliability of the system against noise, it is also possible to provide amplifiers 16a, 16b with protective means which outputs rectangular waves only when input signals into A or B exceed a given standard level. Furthermore, it is also effective to provide such protective means that does not trigger the system in response to one rectangular wave, but only in response to more than one rectangular wave which arise in a given time interval and indicates the occurrence of a grounding fault.

Apart from the above, it is equally important from the standpoint of improving the reliability, that the system is provided with a self-diagnostic capability in order to put itself in good order from time to time. To achieve this, it is necessary for a light emitting diode to function to transmit signals equivalent to those resulting from occurrence of a fault, in order to cause the optomagnetic sensors make the same judgement as they would upon occurrence of an actual fault.

The soundness of the system can be checked by seeing if the indication circuit 22 in Fig 1C produces an indication in response to the fault simulation signals. In this case, in order that persons in charge of maintenance may not mistake these signals for the occurrence an actual fault, it is necessary to provide the system with protective means that outputs the signals to the outside of the system.

Other than the self-diagnosis function mentioned above, it is also useful to see if fault-simulated signals can be output properly upon their input into the amplifiers 16a, 16b, the exclusive "OR" circuit 17, or the integrator 18 in Fig. 1C.

Additionally, whole or partial duplication of the essential part or parts of the system is useful in improving its reliability. A system with "AND" logic using outputs of duplicated circuits is of course expensive, but increases the system reliability.

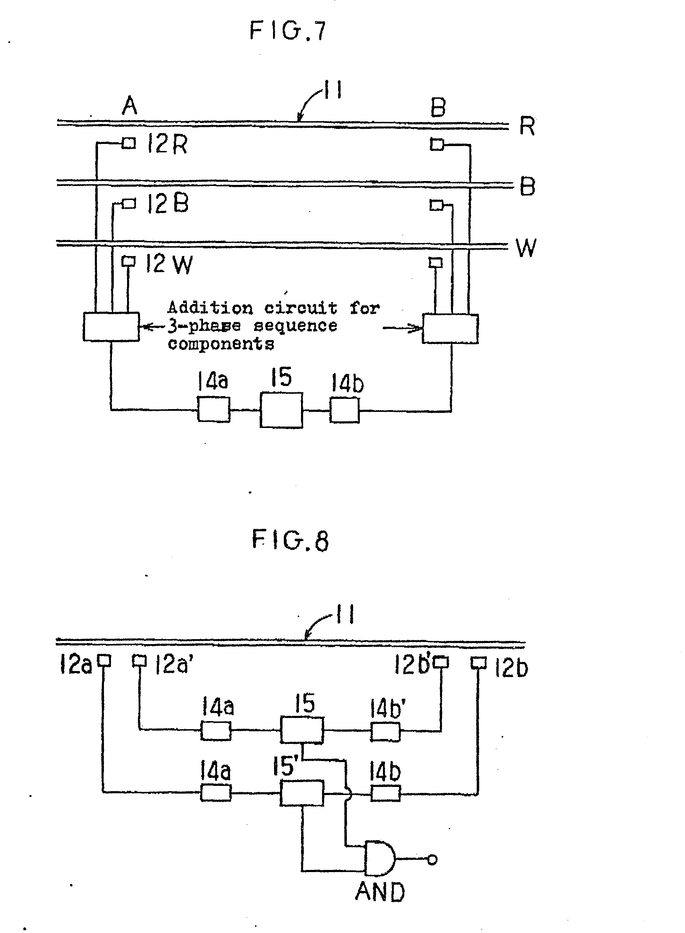

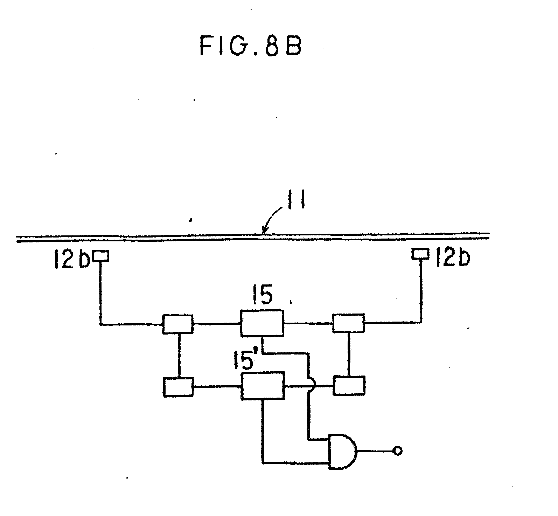

In this connection, Figs. 8A and 8B show examples of a full duplication and a partial duplication of the system respectively. It is interesting to note that making the logic of the discrimination circuit different is more advantageous than making it the same in increasing the noise margin.

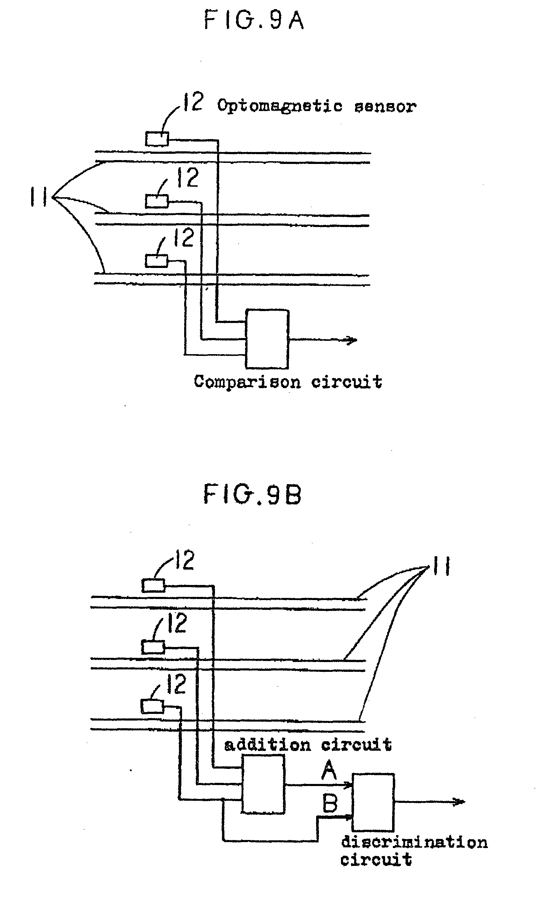

Still another method of making the system self-diagnostic is to see if the optomagnetic sensors always sense a conductor current and transmit a sinusoidal wave in correspondence therewith. The zero-phase sequence method by which three-phase sequence components are added vectorially avoids the drawback that the zero-phase sequence output cannot be monitored because it is always zero; that is, if it is only confirmed that any one of the three-phase components is present and also that the zero-phase sequence output is zero, the soundness of the whole three-phase system is confirmed. In the above checking systems, the former can be realized as shown in Fig. 9A and the latter can be realized by monitoring any one of the three phase components and the zero phase sequence output as shown in Fig. 9B.

## CLAIMS

1. A system for locating a grounding fault on electric power equipment such as electric power cables or gas insulated substations (GIS), which is characterised in that a plurality of optomagnetic sensors (12a, 12b) are installed in relation to the electric power equipment (11) in a scattered or distributed manner so as to detect a level difference or phase difference of magnetism due to conductor current flowing in said electric power equipment, in that two information signals detected by two of said optomagnetic sensors (12a, 12b) are taken out by way of an optical fiber cable (13a, 13b) assigned to an information transmission means, and in that a decision as to whether or not a grounding fault has occurred between said two optomagnetic sensors is made on the basis of said magnetic level difference, or phase difference, or a combination of the two.

2. A system according to claim 1, characterised in that sinusoidal wave signal information related to conductor current sent from two of said optomagnetic sensors (12a, 12b) is re-shaped into substantially rectangular waves so as to make data processing and judgement whether or not a grounding fault has occurred between two optomagnetic sensors on the basis of the result of said data processing.

3. A system according to claim 1 or 2, characterised in that said optomagnetic sensors (12a, 12b) are attached to the exterior of a grounded metallic sheath of the electric power equipment (11).

4. A system according to claim 1 or 2, characterised in that said optomagnetic sensors (12a, 12b) are attached to the interior of a grounded metallic sheath of the electric power equipment (11).

5. A system according to any preceding claim, characterised in that zero-phase sequence information obtained from the vectorial addition of three-phase sequence components is used as information on conductor current, and judgement on whether a grounding fault has occurred between or outside two of said optomagnetic sensors (12a, 12b) is made based on said zero-phase sequence information coming from the two of said optomagnetic sensors.

6. A system according to any preceding claim, characterised in that the reliability of said system is designed to be increased by judging whether two or more than two waves of certain information are contained in a given period of time.

7. A system according to any preceding claim, characterised in that it is operable to monitor the occurrence of unusualness of said optomagnetic sensors based on electric current of each phase coming from said optomagnetic sensors (12a, 12b).

8. A system according to claim 7, characterised in that it is operable to monitor the occurrence of unusualness of said optomagnetic sensors (12a, 12b) based on either the zero-phase sequence component resulting from the vectorial addition of three-phase sequence components, or said zero-phase sequence component and at least one of the three-phase sequence components.

9. A system according to any preceding claim, characterised in that it has a protective circuit that judges rectangular wave output or such other outputs as an integrator (18) transmits to be effective when conductor current has exceeded a predetermined standard level.

10. An apparatus corresponding to a system according to claim 1, which is characterised by having amplifiers (16a, 16b) corresponding to said optomagnetic sensors (12a, 12b), each of said amplifiers having an automatic gain control function to keep the output of said amplifiers effectively at a certain level, and in that an exclusive "OR" circuit (17) is provided on the output side of two of said amplifiers whose outputs are compared with each other.

11. An apparatus according to claim 10, characterised in that it has a self-diagnostic function for checking said system for faults and an indication function for indicating the result of the checking.

12. An apparatus according to claim 11, characterised in that it has a protective function for intercepting those signals indicative of the occurrence of a grounding fault while self-diagnosis is being made.

13. An apparatus according to claim 11 or 12, characterised in that it is able to simulate a grounding fault in making self-diagnosis by modulating the incident light entering said optomagnetic sensors.

14. An apparatus according to claim 11, 12 or 13, characterised in that it has a signal transmitting circuit anywhere in the signal processing circuit (28) to form a grounding fault simulated signals and makes diagnosis concerning the soundness of said apparatus by the use of said simulated signals.

15.    An apparatus according to claim 13 or 14, characterised in that it is composed of fully or partially duplicated circuits so as to compare each output therefrom, and which makes a judgement that said outputs are effective when a couple of said outputs agree.

16.    An apparatus according to claim 15, characterised in that said duplicated circuits are different from each other in logic or in construction.

17.    An apparatus for locating a grounding fault on electric power equipment, characterised by a magnetism-light conversion means (12) operable to convert magnetism induced by an electric current into optical signals, a light-electricity conversion means (14) operable to convert the signals from said magnetism-light conversion means (23) into electric signals, two amplifiers (16a, 16b) with high amplification power operable to amplify the signals from said light-electricity conversion means and reshape them into rectangular waves, a circuit (17) operable to convert the signals from said two amplifiers into an exclusive "OR", integration means (18) operable to integrate the signals from said exclusive "OR" circuit (17), and comparison means (19) operable to compare the signals from said integration means (18) with a certain standard voltage level.

18.    An apparatus according to claim 17, characterised in that it is further provided with means to locate a grounding fault and means to indicate whether the location of the grounding fault is inside or outside a given section (L).

19.    An apparatus according to claim 17 or 18, characterised in that said magnetism-light conversion means (12) is an optomagnetic sensor which makes use of the Faraday effect.

## FIG. 1A

## FIG. 1B

# FIG.IC

Exclusive OR Circuit

16a:

A

16b:

B

40

+Vcc

Integrator  Comparator

17      18      19

20

AND

41

Inversion
circuit

22

LED

RY

BZ

S    Q

F.F.

R        21

RESET

FIG. 1. D

FIG. 1. E

## FIG.2

Magnetic field H

23: Faraday element single crystal :BSO

Z
A
Y
X

incident light

ℓ

Transmitted light

Z
φ
B
Y
X'

## FIG.3

direction of the magnetic field

24: dielectric layer for multi-reflection

26: analyser
27: optical rotator

25: polarizer

12

23:BSO
Faraday element single crystal

## FIG.4

29

28

12: optomagnetic sensor

13: optical fiber

13: optical fiber

meter

30: photodiode

## FIG. 5

| | normal condition | occurrence of a grounding fauet | |
|---|---|---|---|
| | | outside the section L | inside the section L |
| electric cur. at spot A | $\dot{I}_1$ ( ~ ) | $\dot{I}_2$ ( ~ ) | $I_3$ ( ~ ) |
| " " " " at spot B | $\dot{I}_1$ ( ~ ) | $\dot{I}_2$ ( ~ ) | $-I_3$ ( ~ ) |
| output from signal 14a | $\dot{V}_1$ ( ~ ) | $\dot{V}_2$ ( ~ ) | $V_3$ ( ~ ) |
| conditioning sircuit 14b | $\dot{V}_1$ ( ~ ) | $\dot{V}_2$ ( ~ ) | $-V_3$ ( ~ ) |

0165803

# FIG.6

(1) Normal condition (ideal state: no phase difference and no DC component in signals from the spots A and B)

17  0V———————————

18  0V———————————

(2) Normal condition (unideal state)

17  0V

18  0V                                    Comparator's
                                          standard
                                          voltage level

(3) Occurrence of a grounding fault inside the section L
                                              (ideal state)

17  0V

18  0V                                    Comparator's
                                          standard
                                          voltage level

(4) Occurrence of a grounding fault inside the section L (unideal state)

17  0V

18  0V                                    Comparator's
                                          standard
                                          voltage level

0165803

# FIG.7

Addition circuit for 3-phase sequence components

# FIG.8

AND

## FIG.8B

## FIG.9A

12 Optomagnetic sensor

11

12

12

Comparison circuit

## FIG.9B

12

12

12

11

addition circuit

A

B

discrimination circuit